# EUROPEAN PATENT APPLICATION

(11) **EP 0 573 092 A1**
(43) Date of publication of application: **08.12.1993**
(21) Application number: 93201355.0
(22) Date of filing: 11.05.1993
(51) Int. Cl.: B41C 1/055, B41C 1/10, B41M 5/26, B41M 5/36, B41M 5/40

(54) **A method for obtaining an image using a heat mode recording material**

(30) Priority: 05.06.1992 EP 92201632
(71) Applicant: AGFA-GEVAERT naamloze vennootschap, B-2640 Mortsel (BE)
(72) Inventor: Leenders, Luc, c/o Agfa-Gevaert N.V., B-2640 Mortsel (BE)

(57) **Abstract**

The present invention provides a method for making an image comprising the steps of:
- image-wise exposing a heat mode recording material containing on a support (i) a recording layer containing a radiation to heat converting substance and an image forming substance and optionally (ii) a surface layer thereby
- decomposing said recording layer and optionally said surface layer in the exposed areas and
- rubbing said heat mode recording material to remove said optional surface layer and said recording layer in the exposed areas.

## Description

### 1. Field of the invention.

The present invention relates to a method for making images using a heat mode recording material and to a method for making a lithographic printing plate using an imaged heat mode recording material as an original.

### 2. Background of the invention.

In the process for preparing lithographic printing plates contact originals are prepared containing text and graphics. These originals are then used for imaging a printing plate. Such contact originals can be made by manually preparing a paste-up or they can be prepared by the aid of a computer. In the latter case the computer may control an output device, generally a laser, for imaging a recording material.

A commonly used recording material is a silver halide photographic material that offers such advantages as high sensitivity, high density and good resolving power. However a silver halide photographic material requires special liquids for processing and as a consequence a lot of chemical waste is produced. Further silver halide photographic materials are susceptible to ambient light thus requiring handling in the dark.

Due to the above disadvantages of silver halide photographic material, especially the ecological disadvantage, the need for more convenient and ecologically more acceptable recording materials exists. Of course such recording materials should yield images of high density and contrast so that they can be used for imaging photoresists to obtain lithographic printing plates or printed circuits.

Especially interesting recording materials are heat mode recording materials because they are generally not susceptible to ambient light and can thus be handled in day light. Heat mode recording materials are disclosed in e.g. US-P-4.123.309, US-P-4.123.578, US-P-4.157.412, US-P-4.547.456 and PCT application WO 88/04237. The latter application discloses a web having an image forming surface and a porous layer of an image forming substance. The element further comprises a heat sensitive substance. Upon imaging with a laser the image forming surface is liquefied at the exposed parts thereby penetrating the porous layer and improving its adherence to the web while at the non-exposed parts liquefying of the image forming surface does not take place and as a consequence the adherence of the porous layer to the web remains poor. The porous layer can then be removed in the non-exposed areas using a stripping tape or by simply rubbing. Due to the subtle balance of adhesion forces between the porous layer and the image forming surface and the cohesive forces within the porous layer the removal of the porous layer with a stripping tape has to be performed under very stringent conditions and even then lateral cracks of the porous layer in the exposed parts may occur resulting in a decreased image density. The resulting image may be scratch sensitive and a protective layer should be laminated thereto which is inconvenient.

GB-A-2.029.267 discloses a heat mode recording material comprising on a support a metallic recording layer and a protective surface layer. Upon imaging with a laser the density of the metallic recording layer is reduced at the exposed areas due to melting of the metallic layer in these areas. Such a recording material is however unsuitable for imaging a printing plate because of the poor contrast and high fogging level of the image that is obtained.

### 3. Summary of the invention.

It is an object of the present invention to provide a method for making an image of good contrast and high density in an ecological and convenient way.

It is another object of the present invention to provide a method for imaging a lithographic printing plate in an ecological and convenient way using an original of good contrast and high density for imaging the plate.

Further objects will become clear from the description hereinafter.

According to the present invention there is provided a method for making an image comprising the steps of:
- image-wise exposing a heat mode recording material containing on a support a recording layer containing a radiation to heat converting substance and an image forming substance thereby
- decomposing said recording layer in the exposed areas and
- rubbing said heat mode recording material to remove said recording layer in the exposed areas.

According to the present invention there is provided a method for preparing a lithographic printing plate using as an original an image obtainable by the above defined method.

### 4. Detailed description of the invention.

The heat mode recording material to be used in the method according to the present invention comprises on a support a recording layer containing a radiation to heat converting substance and an image forming substance. The recording layer is preferably covered with a surface layer. Upon image-wise exposure to radiation a corresponding image-wise heat pattern will be formed in the recording layer due to the conversion of the radiation into heat by the radiation to heat converting substance. This heat pattern will cause image-wise decomposition of the recording layer and optionally of the surface layer that may be on top thereof. At the sufficiently exposed parts of the recording material the recording layer will be sufficiently decomposed so that the recording layer and optional surface layer can be easily removed at these parts by simply rubbing the recording material with e.g. a dry cotton pad or alternatively with a non-solvent for the recording layer and optional surface layer. In any case swelling of the recording layer and optional surface layer during rubbing should be avoided. The optional surface layer may also be decomposed due to the heat generated at the exposed parts, however this is not a requirement because the decomposition of the recording layer at the exposed parts can be sufficient to also remove the surface layer by rubbing.

The optional surface layer on top of the recording layer offers the advantage that no or little decrease of the density in the non-exposed parts occurs during rubbing which may otherwise occur as a consequence of possible damaging of the recording layer during rubbing.

When the recording material comprises a recording layer and surface layer the total thickness thereof is preferably kept as low as possible. By keeping the layer thickness at a low level the imaged parts of the recording material can be more easily removed and further the sharpness and resolution of the image can be improved in this way. Preferably the total thickness will not exceed 7µm and most preferably will not exceed 5µm.

The recording layer according to the present invention comprises a radiation to heat converting substance and an image forming substance. In an especially preferred embodiment the image forming substance and radiation to heat converting substance are the same substance. The radiation to heat converting substance in connection with the present invention is a compound that is capable of absorbing a substantial amount of the exposure radiation and subsequently releasing the associate energy mainly in the form of heat. Preferably the thickness of the heat mode recording layer is not more than 2.5µm and most preferably not more than 1.5µm. When the thickness of the recording layer becomes too large not all of the recording layer can be removed in the exposed areas so that a high fogging level results.

Suitable radiation to heat converting substances are e.g. carbon black, metals or metal alloys preferably having a low melting point and low conductivity e.g. Bi, Ge, Sn, Te etc., infrared or near infrared dyes as disclosed in e.g. US-4833124, EP-321923, US-4772583, US-4942141, US-4948776, US-4948777, US-4948778 US-4950639, US-4950640, US-4912083, US-4952552, US-5024990 US5023229 etc. or infrared absorbing pigments such as e.g. HEUCODOR metal oxide pigments available from Heubach Langelsheim.

Suitable image forming substances to be used in accordance with the invention are substances that can yield sufficient density in the desired range of the spectrum, e.g. in the visual or in the UV part of the spectrum. Examples of image forming substances are e.g. dyes or dye pigments. In an especially preferred embodiment the image forming substance and radiation to heat converting substance are the same substance. Compounds that can be used as image forming substance and radiation to heat converting substance are e.g. carbon black or metals.

When metals are used in the recording layer they are preferably provided as an integral metal layer preferably by vacuum deposition. Preferably the metal layer will have a thickness such that the optical density thereof is 3 or more. However the metal may also be dispersed as metal particles in the recording layer in combination with other image forming and/or radiation to heat converting substances.

According to the most preferred embodiment of the present invention the recording layer is a layer containing carbon black and a polymeric binder preferably having a good thermal degradation. Examples of binders that can be used are e.g. gelatin, cellulose, cellulose esters e.g. cellulose acetate, nitrocellulose, polyvinyl alcohol, polyvinyl pyrrolidone, a copolymer of vinylidene chloride and acrylonitrile, poly(meth)acrylates polyvinyl chloride, silicone resin etc.. The recording layer may further contain other ingredients such as e.g. wetting agents, matting agents, anti-oxidizing agents etc..

The optional surface layer in accordance with the present invention preferably also contains a polymer that shows good thermal degradation. Examples of polymers that can be used in the surface layer are e.g. gelatin, cellulose, cellulose esters e.g. cellulose acetate, nitrocellulose, polyvinyl alcohol, polyvinyl pyrrolidone, a copolymer of vinylidene chloride and acrylonitrile, poly(meth)acrylates, polyvinyl chloride, a copolymer of styrene and butadiene, silicone resins etc... Preferably used silicone resins are hardened silicone resins.

Preferably the silicone resin contains one or more components one of which is generally a linear silicone polymer terminated with a chemically reactive group at both ends and a multifunctional component as a hardening agent. The silicone resin can be hardened by condensation curing, addition curing or radiation curing.

Condensation curing can be performed by using a hydroxy terminated polysiloxane that can be cured with a multi functional silane. Suitable silanes are e.g. acetoxy silanes, alkoxy silanes and silanes containing oxime functional groups. Generally the condensation curing is carried out in the presence of one or more catalyst such as e.g. tin salts or titanates. Alternatively hydroxy terminated polysiloxanes can be cured with a polyhydrosiloxane polymer in the presence of a catalyst e.g. dibutyltindiacetate.

Addition curing is based on the addition of Si-H to a double bond in the presence of a platinum catalyst. Silicone coatings that can be cured according to the addition curing thus comprise a vinyl group containing polymer, a platinum catalyst e.g. chloroplatinic acid complexes and a polyhydrosiloxane e.g. polymethylhydrosiloxane. Suitable vinyl group containing polymers are e.g. vinyldimethyl terminated polydimethylsiloxanes and dimethylsiloxane/vinylmethyl siloxane copolymers.

Radiation cure coatings that can be used in accordance with the present invention are e.g. U.V. curable coatings containing polysiloxane polymers containing epoxy groups or electron beam curable coatings containing polysiloxane polymers containing (meth)acrylate groups. The latter coatings preferably also contain multifunctional (meth)acrylate monomers.

The surface layer may contain additional substances such as plasticizers, pigments, matting agents, anti-statica etc.. Part of the radiation to heat converting substance may also be incorporated in the surface layer.

The thickness of the surface layer is preferably between 0.1µm and 3µm and more preferably between 0.1µm and 1µm.

The heat mode recording material used in accordance with the invention may contain additional layers such as e.g. one or more layers between the support and the recording layer for improving the adhesion of the recording layer to the support or intermediate layers between the surface layer and recording layer may be provided. In the latter case however these layers should be easily removable at the exposed areas.

According to a preferred embodiment a layer containing a polymer containing covalently bound chlorine is provided between the support and the recording layer. Suitable chlorine containing polymers for use in accordance with the present invention are e.g. polyvinyl chloride, polyvinylidene chloride, a copolymer of vinylidene chloride, an acrylic ester and itaconic acid, a copolymer of vinyl chloride and vinylidene chloride, a copolymer of vinyl chloride and vinyl acetate, a copolymer of butylacrylate, vinyl acetate and vinyl chloride or vinylidene chloride, a copolymer of vinyl chloride, vinylidene chloride and itaconic acid, a copolymer of vinyl chloride, vinyl acetate and vinyl alcohol, chlorinated polyethylene, polychloroprene and copolymers therof, chlorosulfonated polyethylene, polychlorotrifluoroethylene polymethyl-alpha-chloroacrylate etc.

The chlorine containing polymer used in connection with the present invention may be prepared by various polymerization methods of the constituting monomers. For example, the polymerization may be conducted in aqueous dispersion containing a catalyst and activator, e.g., sodium persulphate and meta sodium bisulphite and an emulsifying and/or dispersing agent. Alternatively, the homopolymers or copolymers used with the present invention may be prepared by polymerization of the monomeric components in the bulk without added diluent, or the monomers may be reacted in appropriate organic solvent reaction media. The total catalyst-activator concentration should generally be kept within a range of about 0.01% to about 2.0% by weight of the monomer charge, and preferably within a range of concentration of 0.1% to 1.0%. Improved solubility and viscosity values are obtained by conducting the polymerization in the presence of mercaptans such as ethyl mercaptan, lauryl mercaptan, tertiary dodecyl mercaptan, etc., which are effective in reducing cross-linking in the copolymer. In general, the mercaptans should be used in concentrations of 0.1% to 5.0% by weight, based on the weight of polymerizable monomers present in the charge.

Alternatively the chlorine containing polymer may be prepared by chlorinating homopolymers or copolymers. For example chlorinated rubbers such as polychloroprene may be prepared by reacting a rubber with chlorine gas. In a similar manner chlorinated polyethylene may be prepared.

The chlorine containing polymer may also be included in the recording layer.

Suitable supports for the heat mode recording material used in connection with present invention are preferably non-metallic supports e.g. a polyester film support, paper coated with a polyolefin such as polyethylene, polycarbonate film, polystyrene film etc..

The heat mode recording material in connection with the present invention is preferably exposed using a laser. Preferably used lasers are e.g. semiconductor lasers, YAG lasers e.g. Nd-YAG lasers, Argon lasers etc.. The laser may have a power output between 40 and 7500mW and preferably operates in the infrared part of the spectrum. Rubbing of the image-wise exposed heat mode recording material can be done using a brush, a cotton pad etc.. Rubbing of the heat mode recording material in connection with the present invention is carried out without the presence of a developing liquid. In this way swelling of the recording layer and/or surface layer is avoided and images of good contrast and high density can be obtained.

According to the present invention the image obtained according to the above described method can be used as an original for imaging a photoresist for preparing a printed circuit or a lithographic printing plate.

Thus a lithographic printing plate precursor containing an oleophobic or oleophilic base is imaged using as an original an image obtainable by the above described method so that an image-wise pattern of respectively oleophilic or oleophobic parts is formed on the oleophobic or oleophilic background.

According to a practical embodiment of the present invention for obtaining a lithographic printing plate, a plate precursor containing an aluminium support carrying on a hydrophilic (oleophobic) surface a photosensitive coating of e.g. a photopolymerizable composition or a diazo resin etc. is exposed to actinic radiation in contact with an imaged heat mode recording material of the present invention and is subsequently developed so that an image-wise pattern of oleophilic parts remains on the oleophobic background. Such type of printing plate precursors are described in e.g. EP-A-450199, EP-A-476187, US-P-3971660, EP-A-167751, EP-A-48909, DE-A-3036174, DE-A-3717757, DE-A-3228429, US-P-4268667.

According to another embodiment of the invention for obtaining a lithographic printing plate a silver salt diffusion transfer plate precursor containing a silver halide photosensitive layer and an image receiving layer is camera or contact exposed using an imaged heat mode recording material of the present invention and is subsequently developed according to the silver salt diffusion transfer process. Such type of printing plate precursors are described in e.g. EP-A-410500, EP-A-474922, US-P-4297429.

The present invention will now be illustrated by the following examples without however limiting the invention thereto. All parts are by weight unless otherwise specified.

### EXAMPLE 1

### Sample 1:

To a polyethylene terephthalate support provided with a layer of a copolymer of vinylidenechloride (88 mol%), methyl acryl ate (10 mol%) and itaconic acid (2mol%) in an amount of 170mg/m² and a layer containing 0.28g/m² of gelatin, 0.47g/m² of silica sol 300F (commercially available from BAYER AG) and 1mg/m² of copolymer beads of methylmethacrylate (95mol%) stryrene (2.5mol%) and methacrylic acid (2.5mol%) was coated a recording layer using an aqueous coating solution having the following composition:

| | |
|---|---|
| Carbon black (Printex U obtained from Degussa) | 10% |
| polyvinylpyrrolidon | 2% |
| wetting agent Ultravon W (obtained from CIBA-GEIGY) | 1.5% |

The above solution was coated in such a way that the amount of carbon black contained in the dried layer was 1g/m².

To the recording layer was then coated a surface layer containing 1g/m² of gelatine.

### Sample 2:

To a polyethylene terephthalate support was coated a recording layer using an aqueous coating solution having the following composition:

| | |
|---|---|
| Carbon black (Mitsubishi #30 obtained from Mitsubishi) | 10% |
| Copolymer of vinylidene chloride and acrylonitrile (Saran F220 obtained from Dow Chemical) | 5% |
| wetting agent Solsperse 24000 (obtained from ICI) | 1% |
| wetting agent Solsperse 5000 (obtained from ICI) | 0.5% |

The recording layer was coated such that the amount of carbon black contained therein was 1g/m².

To the recording layer was coated a surface layer having a dry thickness of 2.5µm using the following coating solution:

| | |
|---|---|
| EXXSOL DSP 80/110 naphta¹ | 379.5g |
| vinyl terminated dimethylpolysiloxane | 95g |
| SYL-OFF 7367² | 4g |
| divinyltetramethyl disiloxane complex of platinum ( containing 1.5% of xylene) | 0.56g |

| | |
|---|---|
| ¹ Exxsol DSP 80/110 is a naphta i.e. a mixture of paraffins and in which the content of aromatics has been reduced. | |
| ² Syl-off 7367 is the cross-linker used and is a solution of 71% of methyl hydrogen polysiloxane in ethynylcyclohexene. | |

The silicon surface layer was then cured by heating the sample during 5min. at 130°C.

The above two prepared recording materials were each image-wise exposed using a NdYAG laser operating at 1064nm with an output of 200mW and a spotdiameter (1/e²) of 6.5µm. The linear writing speed of the laser was 13.7m/s. After the exposure the imaging elements were rubbed with a dry cotton pad and the density in the non-exposed (Dₘₐₓ) and exposed (Dₘᵢₙ) parts was measured. The following results were obtained:

| Sample | Dₘₐₓ | Dₘᵢₙ |
|---|---|---|
| 1 | 5.0 | 0.04 |
| 2 | 3.4 | 0.10 |

It can thus be seen that for each of the samples the obtained image has a high density in the non-exposed parts and a low density in the exposed parts and as a result a good contrast.

### EXAMPLE 2

### Sample 3:

To a polyethylene terephthalate support provided with a layer of a copolymer of vinylidenechloride (88 mol%), methyl acryl ate (10 mol%) and itaconic acid (2mol%) in an amount of 170mg/m² was vacuum deposited a bismuth layer as a recording layer such that the optical density thereof was 4.4. To this recording layer was then coated the surface layer described for sample 2 which was also cured as described for sample 2.

### Sample 4:

A similar recording material as sample 3 was prepared with the exception that the optical density of the bismuth recording layer was 3.7 and the surface layer was replaced by a layer of 0.5g/m² of a copolymer of vinyl alcohol (11mol%), vinylacetate (1mol%), vinylbutyral (88mol%) (BUTVAR 76 obtained from Monsanto).

### Sample 5:

A similar recording material as sample 3 was prepared with the exception that the surface layer was replaced by a layer of 0.5g/m² of polymethylmethacrylate.

### Sample 6:

A similar recording material as sample 3 was prepared with the exception that the optical density of the bismuth recording layer was 4.7 and the surface layer was replaced by a layer of 0.5g/m² of a copolymer of styrene (85mol%) and butadiene (15mol%) (Pliolite S5B obtained from Goodyear).

Each of samples 3 to 6 was exposed and processed as described in example 1 and Dₘᵢₙ and Dₘₐₓ were measured as described in example 1. The results obtained were as follows:

| Sample | Dₘₐₓ | Dₘᵢₙ |
|---|---|---|
| 3 | 4.4 | 0.06 |
| 4 | 3.7 | 0.10 |
| 5 | 4.4 | 0.12 |
| 6 | 4.7 | 0.08 |

It can thus be seen that for each of the samples the obtained image has a high density in the non-exposed parts and a low density in the exposed parts and as a result a good contrast.

## Claims

1. A method for making an image comprising the steps of:
- image-wise exposing a heat mode recording material containing on a support a recording layer containing a radiation to heat converting substance and an image forming substance thereby
- decomposing said recording layer in the exposed areas and
- rubbing said heat mode recording material to remove said recording layer in the exposed areas.

2. A method according to claim 1 wherein said radiation to heat converting substance and said image forming substance are the same compound.

3. A method according to claim 2 wherein said radiation to heat converting substance is carbon black or a metal.

4. A method according to any of claims 1 to 3 wherein said heat mode recording material further comprises a surface layer on top of said recording layer.

5. A method according to claim 4 wherein the total thickness of said recording layer and surface layer is not more than 5µm.

6. A method according to claim 4 wherein said surface layer contains a silicon resin.

7. A method according to any of the preceding claims wherein said heat mode recording material further comprises a polymer containing covalently bound chlorine in said recording layer and/or in a optional layer between said support and said recording layer.

8. A method according to any of the preceding claims wherein the thickness of said recording layer is not more than 2.5µm.

9. A method according to any of the preceding claims wherein said image-wise exposure is carried out by a laser.

10. A method for making a lithographic printing plate comprising the steps of image-wise exposing a lithographic printing plate precursor containing an oleophobic or oleophilic base and a photosensitive coating using as an original an image obtainable by the method as defined in any of the preceding claims so that after development of the lithographic printing plate precursor an image-wise pattern of respectively oleophilic or oleophobic parts is formed on the oleophobic or oleophilic base.
